Europäisches Patentamt

European Patent Office

Office européen des brevets

(11) Numéro de publication: **0 337 870 B1**

(12) **FASCICULE DE BREVET EUROPEEN**

(45) Date de publication de fascicule du brevet: **08.09.93**   (51) Int. Cl.5: **G11C 11/40**, G11C 7/00

(21) Numéro de dépôt: **89400980.2**

(22) Date de dépôt: **10.04.89**

(54) **Mémoire et cellule mémoire statiques du type MIS, procédé de mémorisation.**

(30) Priorité: **12.04.88 FR 8804815**

(43) Date de publication de la demande:
**18.10.89 Bulletin 89/42**

(45) Mention de la délivrance du brevet:
**08.09.93 Bulletin 93/36**

(84) Etats contractants désignés:
**DE GB IT**

(56) Documents cités:
**DE-A- 2 901 538**
**US-A- 4 276 616**

**IEEE TRANSACTIONS ON NUCLEAR SCIEN-CE, vol. NS-32, no. 6, décembre 1985, pages 4432-4437, IEEE, New York, US; G.E. DAVIS et al.: "Transient radiation effects in SOI memories"**

(73) Titulaire: **COMMISSARIAT A L'ENERGIE ATO-MIOUE**
**31/33, rue de la Fédération**
**F-75015 Paris Cédex 15(FR)**

(72) Inventeur: **Auberton-Hervé, André-Jacques**
**94, Avenue de Karben**
**F-38120 Saint Egrève(FR)**
Inventeur: **Giffard, Benoît**
**17, Cours Jean Jaurès**
**F-38000 Grenoble(FR)**

(74) Mandataire: **Mongrédien, André et al**
**c/o BREVATOME 25, rue de Ponthieu**
**F-75008 Paris (FR)**

Rank Xerox (UK) Business Services
(3.10/3.6/3.3.1)

## Description

La présente invention se rapporte à une cellule mémoire statique du type MIS (Métal-Isolant-Semiconducteur) pouvant être utilisée dans le domaine de la microélectronique pour la réalisation de mémoires vives servant à la mémorisation d'informations binaires. Cette cellule mémoire est une cellule mémoire statique à accès aléatoire connue sous l'abréviation de SRAM.

Les cellules mémoires statiques connues en technologie MOS (Métal-Oxyde-Semiconducteur) comportent une bascule bistable constituée par quatre transistors MOS ou par deux transistors MOS et deux résistances de haute valeur comme décrit dans un article général sur les mémoires RAM p. 248-252, paru dans VLSI System Design de Muroga Saburo, Edition Wiley Interscience.

Les mémoires statiques à transistors MOS présentent l'avantage de présenter une forte immunité aux parasites notamment électriques. La surface du circuit mémoire est l'élément primordial du coût de fabrication, d'où l'intérêt de fabriquer une cellule mémoire de dimension la plus faible possible pour en réduire son coût le plus possible.

Par ailleurs, on a tout récemment constaté que les transistors MOS et de façon plus générale les transistors MIS, réalisés en technologie silicium sur isolant, connue sous l'abréviation anglo-saxonne SOI, présentaient un transistor bipolaire parasite. Ce transistor parasite se traduit par des difficultés à optimiser le fonctionnement des dispositifs pour la tension nominale d'alimentation (5 volts par exemple).

Cet effet est particulièrement sensible dans les transistors MOS sur SOI, car classiquement, ces transistors sont réalisés avec la zone du canal flottante électriquement. Or, l'effet bipolaire est dû à l'accumulation de porteurs minoritaires dans la zone du canal (trous pour les NMOS (MOS à canal N)), électrons pour les PMOS (MOS à canal P) qui ont pour effet de polariser la jonction source-canal en direct. Ces porteurs minoritaires sont généralement engendrés en nombre plus élevé dans les NMOS.

En outre, les progrès réalisés dans les matériaux SOI font que, aujourd'hui, l'on dispose de substrats d'excellente qualité. Ceci permet donc d'imaginer et de réaliser des circuits MOS extrêmement performants mais corrélativement de favoriser l'effet bipolaire "parasite" car la durée de vie des porteurs est très grande.

Cet effet parasite est d'autant plus difficile à ignorer que les dimensions des transistors sont plus petites.

Cependant, on a envisagé tout récemment d'utiliser ce transistor parasite bipolaire afin d'augmenter le courant de conduction du transistor MOS. Cette utilisation est décrite dans l'article IEEE Transactions on Electron Devices, vol. ED-34, n°4 d'avril 1987 de J.P. COLINGE, intitulé "An SOI voltage-controlled bipolar-MOS device", p. 845-849.

Dans cette utilisation combinée du transistor MOS et de son transistor bipolaire parasite associé, une connexion extérieure reliant les deux transistors est prévue. En effet, la base du transistor bipolaire, constituée par la région du canal du transistor MOS est connectée électriquement à l'électrode de grille du transistor MOS. En outre, l'utilisation conjointe d'un transistor MOS et de son transistor parasite bipolaire associé est décrite dans le document précédent, dans la technologie silicium sur isolant, et en particulier silicium sur oxyde de silicium. Cependant, ce type d'utilisation entraîne une consommation de courant non négligeable par la connexion extérieure.

Dans l'article général ci-dessus sur les RAM, on décrit aussi des mémoires RAM à transistors bipolaires.

Les mémoires statiques à transistors bipolaires ont l'avantage, par rapport aux mémoires à transistors MOS, d'avoir des états de commutation plus rapides entraînant leur utilisation dans des circuits rapides.

Aussi, l'invention a pour objet une cellule mémoire statique du type MIS ne présentant pas les inconvénients de celle de l'art antérieur. En particulier, la cellule mémoire présente un encombrement très réduit. Elle utilise le transistor bipolaire parasite associé à chaque transistor MOS et de façon plus générale à tout transistor MIS, pour la mémorisation à volonté d'une information binaire.

Or, personne, jusqu'à ce jour, n'a envisagé ni décrit l'utilisation du transistor bipolaire parasite associé au transistor MOS pour la mémorisation d'informations binaires.

De façon plus précise, l'invention a pour objet une cellule mémoire statique comprenant :

A) - une bascule bistable formée essentiellement d'un transistor MIS et d'un transistor bipolaire parasite dû à la structure du transistor MIS, les source et drain du transistor MIS constituant respectivement l'émetteur et le collecteur du transistor bipolaire, la région du canal du transistor MIS située entre la source et le drain jouant le rôle de base du transistor bipolaire, cette base etant totalement isolée de l'extérieur de la cellule mémoire, l'électrode de grille du transistor MIS étant isolée électriquement de la région du canal, et

B) - un circuit d'adressage de la bascule pour appliquer, par rapport à la source portée à un potentiel de référence :

    a) - sur l'électrode de grille une tension VG1 inférieure à la tension de seuil VBi de déclenchement du transistor bipolaire par le transistor MIS et sur le drain une tension VD1 supérieure à la tension de seuil VD0 de maintien déclenché du transistor bipolaire, pour maintenir l'un des états "0" ou "1",

b) - sur le drain la tension VD1 et sur l'électrode de grille une tension VG2 supérieure à VBi ou une impulsion lumineuse suffisante pour déclencher les transistors MIS et bipolaire,pour écrire l'état "1", puis la tension VG1,

c) - sur l'électrode de grille la tension VG1 et sur le drain une tension VD2 inférieure à VD0, pour écrire l'état "0", puis la tension VD1.

Par "base totalement isolée électriquement de l'extérieur de la cellule", il faut comprendre "base non accessible de l'extérieur de la cellule".

Cette cellule mémoire ne comportant qu'un seul transistor MIS n'a comme encombrement que celui de ce transistor.

De façon surprenante, les inventeurs ont prouvé qu'il était possible de mémoriser une information binaire sous la forme d'une absence de courant (baptisée état "0") ou de la présence d'un courant (baptisée état "1") dans un seul transistor MOS, du fait de la présence inhérente d'un transistor parasite bipolaire associé. En outre, cette information est présente et stable tant qu'une nouvelle séquence de mémorisation n'a pas été appliquée et que l'alimentation électrique de cette cellule mémoire est maintenue.

Selon l'invention, la source et le drain sont formés d'une zone d'un premier type de conductivité N ou P et le canal d'une zone d'un second type de conductivité P ou N. En particulier les source et drain sont de type N et le canal de type P. Aussi, le matériau utilisé pour former lesdites zones doit être un matériau semi-conducteur permettant la constitution de zones à dopage prédominant de type P (accepteur) et de zones à dopage prédominant de type N (donneur).

Pour que la cellule mémoire de l'invention fonctionne correctement, il est nécessaire que la qualité du matériau semi-conducteur dans laquelle sont définies les zones N et P assure une longueur de diffusion des porteurs la plus grande possible, (c'est-à-dire supérieure à la longueur du canal). Aussi, il est nécessaire d'utiliser des transistors de faible longueur, c'est-à-dire d'une longueur inférieure ou de l'ordre de 1000 nm.

En outre, il est souhaitable que la cellule mémoire soit isolée du substrat. Aussi, les zones de type N et P sont avantageusement définies dans une couche semi-conductrice supportée par un matériau isolant électrique lui-même disposé sur un substrat. La couche semi-conductrice peut être en silicium polycristallin ou monocristallin, en matériau III-V tel que le GaAs, l'InSb, l'InP, etc. En outre, le matériau isolant électrique est choisi parmi $SiO_2$, SiO, $Si_3N_4$, ZnS, le verre, etc.

De préférence, on utilise une couche semi-conductrice en silicium monocristallin supportée par une couche de dioxyde de silicium ($SiO_2$). Ces matériaux ont l'avantage d'une mise en oeuvre simple et bien maîtrisée et de satisfaire aux exigences ci- dessus.

Les moyens d'adressage de la cellule mémoire et en particulier du transistor MIS la constituant peuvent être réduits aux seules sources d'alimentation électrique délivrant les tensions appropriées sur l'électrode de grille, la source et le drain du transistor MIS.

L'invention a aussi pour objet un procédé de mémorisation d'une information binaire dans une cellule mémoire statique telle que définie précédemment.

Ce procédé consiste à appliquer par rapport à la source, portée à un potentiel de référence :

a) - sur l'électrode de grille une tension VG1 inférieure à la tension de seuil VBi de déclenchement du transistor bipolaire par le transistor MIS et sur le drain une tension VD1 supérieure à la tension de seuil VD0 de maintien déclenché du transistor bipolaire, pour maintenir l'un des états "0" ou "1",

b) - sur le drain la tension VD1 et sur l'électrode de grille une tension VG2 supérieure à VBi ou une impulsion lumineuse suffisante pour déclencher les transistors MIS et bipolaire, pour écrire l'état "1", puis la tension VG1,

c) - sur l'électrode de grille la tension VG1 et sur le drain une tension VD2 inférieure à VD0, pour écrire l'état "0", puis la tension VD1.

L'invention se rapporte encore à une mémoire statique comprenant une matrice de cellules mémoires, telles que définies précédemment, reliées à des lignes et à des colonnes d'adressage, l'adressage de cette mémoire consistant à appliquer par rapport aux sources portees à un potentiel de référence :

a) - sur chaque ligne d'adressage une tension VE0 inférieure à la tension VBi de seuil de déclenchement des transistors bipolaires par les transistors MIS et sur chaque colonne d'adressage une tension VM1 supérieure à la tension VD0 de seuil de maintien déclenché des transistors bipolaires, pour maintenir les états "0" ou "1" mémorisés,

b) - sur la colonne d'adressage de la cellule mémoire ij à adresser une tension VM2 supérieure à VM1 et sur la ligne d'adressage de la cellule à adresser une tension VE1 supérieure à la tension VBi pour la tension VM2 et inférieure à VBi pour la tension VM1, sur les autres lignes d'adressage la tension VE0 et sur les autres colonnes d'adressage la tension VM1, pour écrire un "1" dans la cellule mémoire adressée,

c) - sur toutes les autres lignes d'adressage la tension VE1 et sur toutes les autres colonnes d'adressage la tension VM1, et sur la ligne d'adressage de la cellule $\bar{i}\bar{j}$ à adresser la tension VE0 et sur sa colonne d'adressage une tension VMO inférieure à VD0 puis la tension VM1 et enfin la tension VE0 sur toutes les lignes d'adressage, pour écrire l'état "0" dans la cellule mémoire $\bar{i}\bar{j}$ adressée.

Le circuit d'adressage de chaque cellule de la mémoire comporte avantageusement une première diode reliée d'une part à la colonne d'adressage correspondante et d'autre part au drain de la cellule et une deuxième diode reliée d'une part, à la fois, à la ligne d'adressage correspondante et à l'électrode de grille de la cellule et d'autre part à son drain.

Toutes les tensions données représentent des valeurs absolues. Dans le cas d'un transistor de type N, les tensions sont positives et les diodes sont connectées dans le sens passant, des ligne et colonne d'adressage vers le transistor. Dans le cas d'un transistor de type P, les tensions sont négatives et les diodes sont connectées en sens inverse.

D'autres caractéristiques et avantages de l'invention ressortiront mieux de la description qui va suivre, donnée à titre illustratif et non limitatif en référence aux dessins annexés, dans lesquels :

- la figure 1 représente, schématiquement en coupe longitudinale, un transistor MOS constituant, selon l'invention, une bascule bistable d'une cellule mémoire statique,
- la figure 2 est une représentation symbolique de la bascule de la figure 1, permettant de décrire le fonctionnement de la cellule mémoire selon l'invention,
- la figure 3 est un diagramme donnant les variations de Be en fonction d'Ic, Be étant le gain en courant du transitor bipolaire caractéristique de l'effet bipolaire de la cellule mémoire de l'invention et Ic le courant traversant le collecteur du transistor bipolaire,
- la figure 4 est un schéma partiel d'une mémoire statique formée d'une matrice de cellules mémoires selon l'invention, et
- la figure 5 est un schéma électrique d'une cellule mémoire complète de l'invention montrant le circuit d'adressage de cette cellule dans une matrice de cellules.

La description qui va suivre se rapporte à une cellule mémoire statique du type MOS réalisée en technologie silicium sur isolant compte tenu de l'intérêt d'une telle technologie. Mais bien entendu, comme decrit précédemment, l'invention est d'application beaucoup plus générale. En outre, la source et le drain du transistor MOS sont de type N et le canal de ce transistor de type P, bien qu'il soit possible d'utiliser des source et drain de type P et un canal de type N. Dans ce cas, il faut simplement changer le signe des tensions et des courants électriques utilisés.

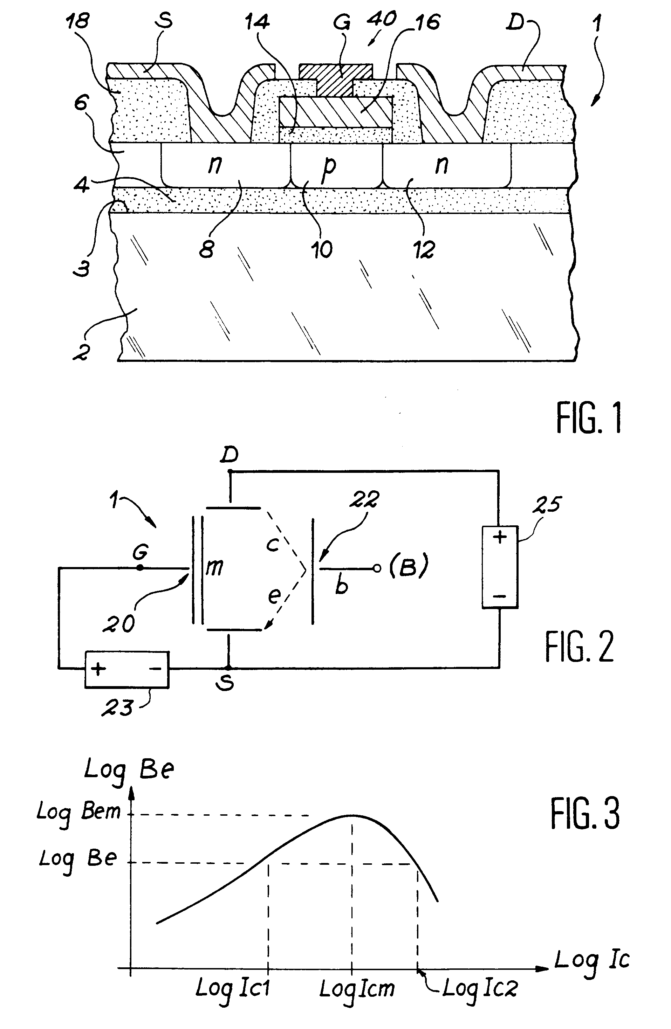

En référence à la figure 1, la cellule mémoire selon l'invention et en particulier la bascule bistable 1 de cette cellule sont formées sur un substrat semi-conducteur monocristallin 2 en silicium pourvu à sa surface supérieure 3 d'une couche d'oxyde de silicium 4 surmontée d'une couche semi-conductrice 6 monocristalline, en silicium.

Les couches isolante 4 et semi-conductrice 6 ont une épaisseur respectivement de 300 nm et de 200 nm. Elles sont obtenues en particulier selon la technique SIMOX décrite notamment dans l'article de P.L.F. HEMMENT et al. de Nuclear Instruments and Methods 209/210, 1983, p.157-164, intitulé "Formation of Buried Insulating Layers in Silicon by the Implantation of High Doses of Oxygen".

Cette technologie consiste à implanter dans le substrat des ions d'oxygène à forte dose puis à recuire le substrat implanté à haute température en vue d'obtenir une couche isolante enterrée. Cette technique d'obtention d'une couche isolante enterrée est celle qui permet d'avoir des valeurs élevées de Bem (valeur maximale de Be, Be caractérisant le gain de l'effet bipolaire, voir figure 3) nécessaires au fonctionnement de la cellule selon l'invention.

Trois zones semi-conductrices 8, 10, 12 dopées de type respectivement N, P, N définissant ainsi deux jonctions N-P 8-10 et 10-12 sont formées par implantation ionique, de façon connue, dans la couche semi-conductrice 6. Les zones 8 et 12 contiennent environ $5.10^{15}$ ions arsenic/cm$^2$ et la zone 10 environ $10^{13}$ ions bore/cm$^2$.

La bascule de la cellule mémoire comprend de plus un matériau isolant 14 en $SiO_2$ de 25 nm d'épaisseur recouvrant totalement la région 10 de type P et isolant électriquement cette dernière d'une électrode de grille 16 par exemple en silicium polycristallin dopé avec 5 à 10% de phosphore, de 400nm d'épaisseur.

Cette électrode 16 ainsi que les zones semi-conductrices externes 8 et 12 de type N sont reliées à l'extérieur de la cellule à l'aide de trois connexions dénommées respectivement G, S et D, réalisées en particulier en aluminium ; une couche isolante 18 gravée de façon appropriée assure l'isolation électrique de ces trois connexions S, G et D. Cette couche 18 est en particulier une couche de $SiO_2$ de 400 nm d'épaisseur.

Les connexions S, G et D sont réalisées en particulier dans une couche d'aluminium gravée de façon appropriée, de 1000 nm d'épaisseur.

Selon l'invention, la zone centrale 10 de type P n'est pas reliée à l'extérieur de la cellule mémoire de l'invention et en est même isolée grace à la couche de SiO₂, 4.

Cette cellule mémoire, selon l'invention, cumule les effets physiques d'un transistor MOS, en surface, sous l'électrode 16 et d'un transistor bipolaire à jonctions, en volume, ces deux effets étant nécessaires pour le fonctionnement de la cellule mémoire.

Selon l'invention, les régions 8 et 12 de type N constituent respectivement la source et le drain du transistor MOS et la région 10 de type P le canal de ce transistor. En outre, les zones 8, 10 et 12 constituent respectivement l'émetteur, la base et le collecteur du transistor bipolaire.

La figure 2 est le schéma électrique équivalent de la bascule bistable 1 de la cellule mémoire de la figure 1. Sur cette figure, les transistors sont représentés symboliquement; le transistor MOS porte la référence 20 et le transistor bipolaire porte la référence 22.

La connexion notée B est une connexion fictive qui n'est pas accessible de l'extérieur de la cellule mémoire. Elle représente la zone semi-conductrice 10 de type P ou base du transistor bipolaire 22.

Le potentiel électrique de la cellule mémoire présent au point S étant pris comme référence, les tensions présentes entre les points G, D, B d'une part et S d'autre part, sont notées respectivement VG, VD, VB. Ces tensions sont appliquées à l'aide de deux sources d'alimentation électrique 23 et 25, la source 23 étant branchée entre la source et l'électrode de grille et la source 25 entre la source et le drain. Les courants circulant dans les branches m, c, e, b, sont notés respectivement Im, Ic, Ie et Ib. Im représente le courant circulant du drain vers la source , Ic le courant entrant dans le collecteur , Ie le courant sortant de l'émetteur et Ib le courant entrant dans la base.

On décrit ci-après le fonctionnement isolé du transistor MOS, puis celui du transistor bipolaire et enfin le fonctionnement combiné des transistors MOS et bipolaire pour la mémorisation de l'information "1" ou "0".

## I - FONCTIONNEMENT ISOLE DU TRANSISTOR MOS

VD étant positif et fixé à VD1, il existe une tension VG = VGT telle que pour VG<VGT le transistor MOS 20 soit bloqué avec Im nul ou négligeable et pour VG>VGT le transistor MOS soit passant avec Im>0. VGT correspond à la tension de seuil de déclenchement du transistor MOS.

Lorsque Im est non nul, le passage du courant Im provoque la création, principalement dans la jonction N-P (côté drain) 10-12, de paires de porteurs électriques électron + trou par un phénomène de multiplication. Le nombre de porteurs créés est une fonction croissante de Im et de VD. Les trous créés vont charger la zone centrale 10 de type P, ce qui sur la figure 2, équivaut à attribuer à Ib une valeur Ib1 correspondante non nulle. Ce courant Ib1 sert dans le fonctionnement combiné des transistors MOS et bipolaire à amorcer le fonctionnement du transistor bipolaire.

## II - FONCTIONNEMENT ISOLE DU TRANSISTOR BIPOLAIRE

VD étant positif et fixé, il existe une tension VDM telle que pour VD>VDM, le transistor bipolaire 22 soit fortement conducteur par suite d'un phénomène d'avalanche dans la jonction N-P (côté drain) 10-12. Ce phénomène de "claquage base en l'air", dénommé ainsi car la connexion B n'est pas reliée à l'extérieur de la cellule mémoire, est la limite de fonctionnement de la cellule mémoire. Pour VD<VDM, il existe dans la jonction N-P 10-12 un phénomène de faible multiplication entraînant la création de paires électron + trou.

Ce phénomène est analogue au phénomène de multiplication décrit pour le fonctionnement du transistor MOS 20; il est également une fonction croissante à la fois de VD et de Ic. Le courant de trous Ib est égal à Ib2 dans ce cas.

Le courant de trous est caractérisé par la valeur Mu. Mu correspond au rapport Ib2/Ic et est supposé pour la clarté de la description ne dépendre que de VD ; Mu est une fonction croissante de VD.

En outre, pour une valeur déterminée de Ic, il existe une valeur caractérisant l'effet bipolaire de la cellule mémoire que l'on appelle Be. Be est défini comme le rapport d'ic/Ib avec Ib = Ib1 + Ib2 dans le cas du fonctionnement combiné des transistors MOS et bipolaire.

Les variations de Be en fonction d'Ic sont données sur la figure 3. La courbe de la figure 3 représente en fait LogBe en fonction de Log(Ic). La fonction Be est une fonction qui présente un maximum quand Ic augmente. Les coordonnées du maximum sont Bem et Icm. Sur cette figure, on a aussi porté deux valeurs d'ic de part et d'autre du maximum notées Ic1 et Ic2.

Pour Ib = Ib2, les relations précédentes Ic = Be.Ib et Ic.Mu = Ib2 conduisent à deux solutions: soit le produit MuxBe vaut 1, soit Ic = Ib = 0. Le premier cas correspond à un auto-entretien du courant du transistor bipolaire 22,autrement dit à un maintien déclenché du transistor. Pour une valeur déterminée de Mu, trois cas se présentent :

a) - Bem est trop faible et tel que MuxBem<1, l'auto-entretien n'est pas possible ; le seul point de fonctionnement possible du transistor bipolaire est Ic = Ib = 0 ;

b) - Bem vaut exactement 1/Mu et il n'y a qu'une seule valeur possible d'Ic qui assure l'auto-entretien ; cette valeur est Icm ;

c) - Bem est supérieur à 1/Mu et il existe deux valeurs possibles d'Ic qui sont Ic1 et Ic2, qui satisfont à la relation BexMu = 1. La plus faible de ces deux valeurs, Ic1 conduit à un équilibre instable et toute perturbation de cet équilibre est renforcée et entraîne le déséquilibre, soit vers le point Ic = Ib = 0, soit vers la deuxième valeur Ic2 qui est un équilibre stable.

## III - FONCTIONNEMENT COMBINE DES TRANSISTORS MOS ET BIPOLAIRE

Ce fonctionnement comporte un état de repos, un cycle d'écriture d'un "1", un état de mémorisation (ou maintien) d'un "1" ou d'un "0" et un état d'écriture d'un "0".

Dans la suite du texte, on appelle VD0 la tension entre la source et le drain qui correspond à Mu = 1/Bem. En outre, VD0 est inférieur à VDM. VD0 correspond au seuil de maintien déclenché de l'effet bipolaire. On appelle, par ailleurs, VBi la tension VG qui déclenche le transistor bipolaire par le courant Ib1 engendré par le transistor MOS pour une tension VD donnée. Cette tension de seuil VBi est une fonction décroissante de la tension VD appliquée au drain.

### 1°) - Etat de repos

On applique sur l'électrode 16 un potentiel tel que VG = VG1, VG1 étant inférieur à VBi, et sur le drain 12 un potentiel tel que VD = VD1, VD1 étant inférieur à VDM et supérieur à VD0 de façon à ce que Mu soit supérieur à 1/Bem (voir figure 3).

Le courant Im est alors nul et le transistor bipolaire est bloqué au point Ic = Ib = 0.

Cet état de repos est également l'état de mémorisation d'un '0".

### 2°) - Cycle d'écriture d'un "1"

On maintient la tension VD1 entre la source et le drain et on applique transitoirement sur la grille un potentiel tel que VG passe à une valeur VG2 supérieure à VGT, ce qui provoque le passage d'un courant Im et d'un courant de multiplication Ib1. Ce courant Ib1 amorce le transistor bipolaire et, si Ib1 est suffisamment important, autrement dit si VG2 > VBi, Ic atteint la valeur Ic1 (voir figure 3) pour laquelle le produit BexMu vaut 1. Ce point est instable et le transistor bipolaire se stabilise alors à Ic = Ic2, point stable d'auto-entretien. L'état "1" est alors mémorisé. Le passage du point instable Ic1 au point stable Ic2 correspond au déclenchement du transistor bipolaire.

On redescend alors à VG inférieur à VBi.

### 3°) - Etat de mémorisation d'un "1"

Le transistor bipolaire s'est stabilisé à Ic = Ic2 et le transistor MOS engendre un courant Ib1 insuffisant pour déclencher le transistor bipolaire, il peut être par exemple bloqué. La présence de ce courant Ic2 non nul est l'image de la mémorisation de l'information binaire notée "1".

### 4°) - Cycle d'écriture d'un "0"

Partant de l'état de mémorisation d'un "1" ou de l'état de repos, VD est ramené à une tension VD2 inférieure à VD0 de façon à ce que le produit BemxMu soit inférieur à 1. Dans ces conditions, le seul point de fonctionnement du transistor bipolaire, en l'absence d'un courant Ib1 dû au transistor MOS, est Ic = Ib = 0. L'état "0" est alors mémorisé.

VD est ensuite ramené à sa valeur VD1 de l'état de repos.

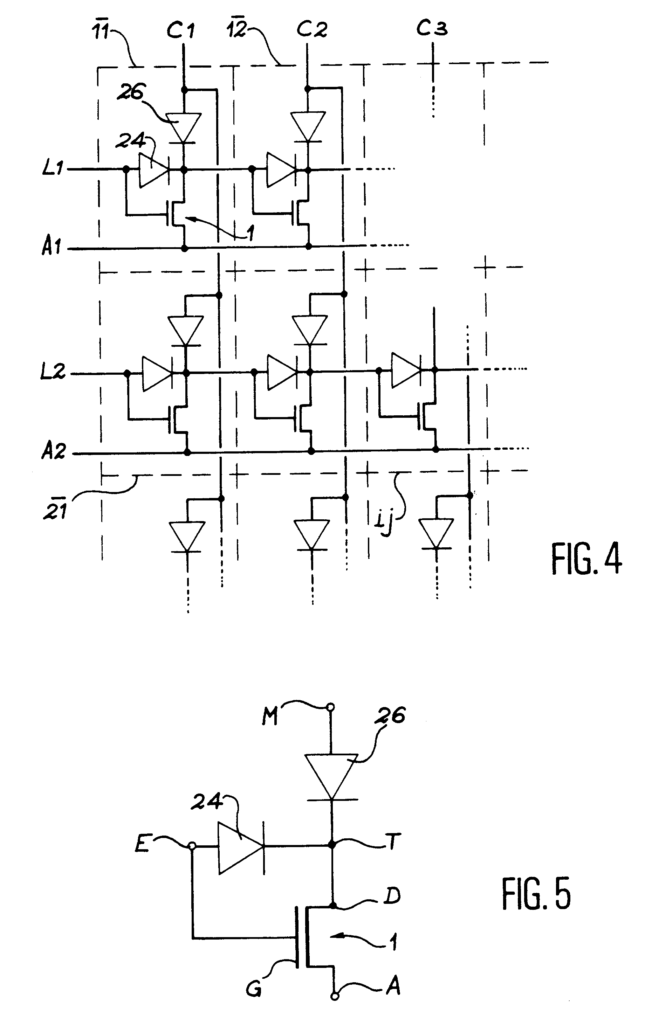

L'utilisation d'une cellule mémoire telle que décrite précédemment est rendue plus attrayante lorsqu'il est possible de regrouper plusieurs de ces cellules, comme représenté sur la figure 4, sous forme d'une matrice, adressées suivant des lignes Li et des colonnes Cj, i et j étant des entiers positifs (1, 2, 3,...) ; l'adressage d'une ligne Li et d'une colonne Cj données correspond à une seule cellule mémoire ij. Les conducteurs Ai portent les sources des cellules mémoires ij̄ à un potentiel de référence.

Pour réaliser l'adressage d'un seul point mémoire, il est nécessaire que ce dernier ne réagisse qu'à l'action d'une ligne et d'une colonne. A cet effet, on adjoint alors à la bascule 1 décrite précédemment un circuit d'adressage; ce circuit d'adressage plus le transistor MOS précédent (figure 1) ou bascule forment une cellule mémoire proprement dite d'une mémoire. Une cellule mémoire complète d'une mémoire est représentée sur la figure 5.

Le circuit d'adressage représenté sur cette figure est constitué de deux diodes 24 et 26. Un tel circuit est parfaitement bien adapté au dispositif de mémorisation 1 formé d'un seul transistor MOS selon l'invention. La diode 26 est reliée dans le sens passant, d'une part à la colonne Cj d'adressage correspondante, et d'autre part, au drain du transistor MOS de la cellule ij̄. La diode 24 est reliée dans le sens passant, d'une part, à la fois, à la ligne d'adressage Li correspondante, à l'électrode de grille de la cellule ij et, d'autre part à son drain.

Sur cette figure 5, les potentiels sont référencés par rapport à la connexion A. Les tensions présentes entre les points E et M d'une part et A d'autre part sont désignées ci-après respectivement par VE, le point E correspondant à la ligne d'adressage Li des éléments binaires, et par VM le point M correspondant à la colonne d'adressage Cj des mots mémoires. Le potentiel du point A est le potentiel de référence de la cellule mémoire et est appliqué en continu sur les sources 8 des transistors MOS.

Pour simplifier, les diodes 24 et 26 sont supposées idéales, c'est-à-dire qu'elles ne présentent pas de tension de mise en direct et pas de courant en inverse.

Avec VBi la tension de seuil de déclenchement du transistor bipolaire 22, définie dans le paragraphe III, on utilise deux valeurs de tension VE classées comme suit, $VE0 < VBi < VE1$ pour la tension VM2 et $VE0 < VE1 < VBi$ pour la tension VM1.

En outre, avec VD0 la tension limite de VM (correspondant au produit $BemxMu = 1$), on utilise trois valeurs de tension VM classées comme suit $VM0 < VD0 < VMI < VM2 < VDM$.

Par ailleurs, il existe des couples de tension VE et VM tels que l'écriture de l'état "1" ne se produise pas dans le transistor MOS, ce qui est le cas pour le couple VE1 et VM1, alors que pour d'autres couples on provoque l'écriture de l'état "1", ce qui est le cas pour VE1 et VM2. Enfin, on a $VE1 = VM1$. En effet, les tensions VE1 et VM1 sont choisies pour que le courant Ib1 engendré par le transistor MOS soit suffisamment faible pour que le courant Ic conduise à une valeur de Be telle que $BexMu < 1$ ne permettant pas un déclenchement du transistor bipolaire. Par ailleurs, les tensions VE1 et VM2 sont choisies de façon à déclencher le transistor bipolaire (Ib1 étant tel que $Ic \geq Ic1$).

On décrit, ci-après, à titre d'exemple l'adressage de la cellule mémoire $\overline{11}$ dans une matrice de cellules mémoires de l'invention.

A) : Etat de repos

On applique sur toutes les lignes d'adressage L1, L2,... et donc les électrodes des cellules mémoires une tension telle que $VE = VE0$ et, sur tous les drains ou colonnes d'adressage C1, C2, C3,... une tension telle que $VM = VM1$. Les transistors MOS 20 ne peuvent pas déclencher les transistors bipolaires et les transistors bipolaires ont un courant soit nul, soit défini par le point Ic2 de la figure 3, suivant l'état mémorisé ("0" ou "1").

B) : Cycle d'écriture d'un "1"

On applique sur l'électrode ou la ligne L1 d'adressage de la cellule mémoire $\overline{11}$ une tension telle que $VE = VE1$ et sur le drain (ou la colonne d'adressage C1) de cette cellule une tension telle que $VM = VM2$. Les autres lignes L2,... et colonnes C2, C3,... restent dans l'état de repos A. Dans ces conditions, la cellule $\overline{11}$ concernée passe à l'état "1" alors que toutes les autres continuent à mémoriser leur état antérieur (quel que soit le couple de tension (VE0, VM1), (VE0, VM2), (VE1, VM1) qui leur est appliqué). Les tensions sont ensuite ramenées à l'état de repos A.

C) : Cycle d'écriture d'un "0"

On applique sur toutes les lignes d'adressage L2, ... autres que la ligne L1 une tension telle que $VE = VE1$ et sur toutes les colonnes C2, C3,... autres que la colonne C1, une tension VM1 et sur la ligne L1 ou électrode adressée une tension telle que $VE = VE0$ et sur la colonne adressée C1 ou drain adressé une tension telle que $VM = VM0$. La cellule adressée ne peut maintenir son état "1" et est donc mise à l'état "0".

Les autres cellules mémoires mémorisent leur état antérieur. En particulier les cellules situées sur la même colonne C1 que la cellule $\overline{11}$ adressée sont alimentées au noeud T de la figure 5 à travers la diode 24 par la tension VE1 ($VE1 > VM0$). La diode 26 évite que la tension VE1 ne soit transmise dans ce cas au point M.

De même, la diode 24 évite que la tension VM ne soit transmise au point E dans tous les cas où $VM > VE$.

Après cette opération d'écriture d'un "0", la tension VM de la cellule mémoire $\overline{11}$ est passée à VM1, puis les lignes dans leur ensemble sont passées à VE0 ; l'ensemble des cellules mémoires sont alors dans l'état de repos A.

D) : Cycle de lecture

Il n'existe pas à proprement parler de cycle de lecture. En effet, il est procédé à une écriture d'un état donné "1" ou "0" avec détection simultanée du changement éventuel d'état par le passage éventuel d'un courant additionnel dans la colonne C1 reliée à M permettant de déterminer l'état antérieur; la valeur lue est alors réécrite.

La détection du changement éventuel d'état peut être faite de façon classique.

La cellule mémoire statique de l'invention utilise de façon active le transistor MOS et le transistor bipolaire inhérent à la structure MOS. Elle permet une mémorisation d'un état "1" ou "0" comme les cellules statiques MOS de l'art antérieur en n'utilisant qu'un seul transistor MOS au lieu de quatre ; l'encombrement de cette cellule mémoire est donc celui de cet unique transistor MOS.

Dans le but d'obtenir un effet mémoire très précis avec la cellule mémoire de l'invention, on utilise de préférence (figure 1) un substrat en silicium monocristallin 2 avec une couche d'oxyde de silicium enterrée 4 afin d'augmenter le paramètre Be ; cette couche enterrée, recuite à haute température de l'ordre de 1300°C, permet d'améliorer les propriétés électriques du substrat 2 et, donc celles de la couche 6 ainsi que celles de la couche d'oxyde entraînant une augmentation du gain Be du transistor bipolaire. En outre, le choix de la structure NPN (ou éventuellement PNP) et de jonctions N-P abrupte permet d'augmenter le paramètre Mu. En outre, l'utilisation d'un transistor MOS de longueur très faible (de l'ordre du micromètre) augmente encore le paramètre Be.

A titre d'exemple, on donne ci-après les différentes valeurs de tensions appliquées à une cellule mémoire de l'invention, fabriquée par le procédé SIMOX et comportant un dopage N de $5.10^{15}$ ions arsenic/cm$^2$, un dopage P de $1.10^{13}$ ions bore/cm$^2$, un canal de 1000nm de long, une couche de $SiO_2$ enterrée de 300nm d'épaisseur, une couche de silicium monocristallin de 200nm, un oxyde de grille de 25nm d'épaisseur, une grille en silicium polycristallin de 400nm d'épaisseur, des connexions source, drain et grille en aluminium de 1000nm d'épaisseur.

a) Cellule mémoire seule
VD0 = 3,5V VD1 = 3V VD2 = 4V
VBi = 0,5V VG1 = 0V Tension de référence source = 0V
VG2 = 4 V
b) Cellule mémoire dans une matrice
VD0 = 3,5V VE0 = 0V VE1 = 4V
VBi = 0,5V VM0 = 3V VM1 = 4V VM2 = 5V

Le déclenchement du transistor bipolaire et du transistor MIS de la cellule mémoire ci-dessus peut aussi être obtenu en éclairant le transistor (figure 1) à l'aide d'une lumière blanche fournie par une lampe du type lampe de projecteur avec une puissance de 1 $\mu$W/$\mu$/m$^2$

**Revendications**

1. Cellule mémoire statique comprenant :
A) - une bascule bistable (1) formée essentiellement d'un transistor MIS (20) et d'un transistor bipolaire (22) parasite dû à la structure du transistor MIS, les source (8) et drain (12) du transistor MIS constituant respectivement l'émetteur et le collecteur du transistor bipolaire, la région du canal (10) du transistor MIS située entre la source et le drain jouant le role de base du transistor bipolaire, cette base étant totalement isolée de l'extérieur de la cellule mémoire, l'électrode (16) de grille du transistor MIS étant isolée électriquement de la région du canal (10), et
B) - un circuit d'adressage (23, 25) de la bascule pour appliquer, par rapport à la source (8) portée à un potentiel de référence :
a) - sur l'électrode de grille (16) une tension VG1 inférieure à la tension de seuil VBi de déclenchement du transistor bipolaire par le transistor MIS (20) et sur le drain une tension VD1 supérieure à la tension de seuil VD0 de maintien déclenché du transistor bipolaire (22), pour maintenir l'un des états "0" ou "1",
b) - sur le drain (12) la tension VD1 et sur l'électrode de grille (16) une tension VG2 supérieure à VBi ou une impulsion lumineuse suffisante pour déclencher les transistors MIS et bipolaire, pour écrire l'état "1", puis la tension VG1,
c) - sur l'électrode de grille (16) la tension VG1 et sur le drain (12) une tension VD2 inférieure à VD0, pour écrire l'état "0", puis la tension VD1.

2. Cellule mémoire selon la revendication 1, caractérisée en ce que la source et le drain (8, 12) sont formés d'une zone d'un premier type de conductivité, le canal (10) d'une zone d'un second type de conductivité, ces zones étant définies dans une couche semi-conductrice (6) supportés par un matériau isolant (4) électrique.

3. Cellule mémoire selon la revendication 2, caractérisée en ce que la couche semi-conductrice (6) est en silicium monocristallin.

4. Cellule mémoire selon la revendication 2 ou 3, caractérisée en ce que le matériau isolant (4) est du dioxyde de silicium.

5. Cellule mémoire selon l'une quelconque des revendications 1 à 4, caractérisée en ce que le circuit d'adressage (23, 25) comprend une première source d'alimentation électrique (23) branchée entre la source (8) et l'électrode de grille (16) et une seconde source d'alimentation électrique (25) branchée entre la source (8) et le drain (12).

6. Procédé de mémorisation d'une information binaire dans une cellule mémoire statique comportant une bascule bistable formée essentiellement d'un transistor MIS (20) dont l'électrode de grille (16) est isolée électriquement de la région du canal (10) du transistor MIS et d'un transistor bipolaire (22) parasite dû à la structure du transistor MIS, les source (8) et drain (12) du transistor MIS constituant respectivement l'émetteur et le collecteur du transistor bipolaire, la région du canal (10) du transistor MIS, située entre la source et le drain jouant le rôle de base du transistor bipolaire, cette base étant totalement isolée électriquement de l'extérieur de la cellule mémoire, procédé consistant à appliquer, par rapport à la source portée à un potentiel de référence :

a) - sur l'électrode de grille (16) une tension VG1 inférieure à la tension de seuil VBi de déclenchement du transistor bipolaire par le transistor MIS (20) et sur le drain une tension VD1 supérieure à la tension de seuil VD0 de maintien déclenché du transistor bipolaire (22), pour maintenir l'un des états "0" ou "1",

b) - sur le drain (12) la tension VD1 et sur l'électrode de grille (16) une tension VG2 supérieure à VBi ou une impulsion lumineuse suffisante pour déclencher les transistors MIS et bipolaire, pour écrire l'état "1", puis la tension VG1,

c) - sur l'électrode de grille (16) la tension VG1 et sur le drain (12) une tension VD2 inférieure à VD0, pour écrire l'état "0", puis la tension VD1.

7. Mémoire statique comprenant une matrice de cellules mémoires réparties suivant des lignes et des colonnes, des lignes (Li) et des colonnes (Cj) d'adressage de ces cellules mémoires, caractérisée en ce que chaque cellule mémoire comprend :

A) - une bascule bistable (1) formée essentiellement d'un transistor MIS et d'un transistor bipolaire parasite dû à la structure du transistor MIS, les source (8) et drain (12) du transistor MIS (20) constituant respectivement l'émetteur et le collecteur du transistor bipolaire (22), la région du canal (10) du transistor MIS située entre la source et le drain jouant le rôle de base du transistor bipolaire, cette base étant totalement isolée de l'extérieur de la cellule mémoire, l'électrode de grille (16) du transistor MIS étant isolée électriquement de la région du canal (10), et

B) - un circuit d'adressage (24, 26) de la bascule, l'adressage d'une cellule mémoire (ij) consistant à appliquer, par rapport aux sources des transitors MIS portées à un potentiel de référence :

a) - sur chaque ligne d'adressage (Li) une tension VE0 inférieure à la tension VBi de seuil de déclenchement des transistors bipolaires par les transistors MIS et sur chaque colonne d'adressage (Cj) une tension VM1 supérieure à la tension VD0 de seuil de maintien déclenché des transistors bipolaires, pour maintenir les états "0" ou "1" mémorisés,

b) - sur la colonne d'adressage de la cellule mémoire (īj) à adresser une tension VM2 supérieure à VM1 et sur la ligne d'adressage de la cellule à adresser une tension VE1 supérieure à la tension VBi pour la tension VM2 et inférieure à VBi pour la tension VM1, sur les autres lignes d'adressage la tension VE0 et sur les autres colonnes d'adressage la tension VM1, pour écrire un "1" dans la cellule mémoire adressée,

c) - sur toutes les autres lignes d'adressage la tension VE1 et sur les autres colonnes d'adressage la tension VM1 et sur la ligne d'adressage de la cellule (īj) à adresser la tension VE0 et sur sa colonne d'adressage une tension VM0 inférieure à VD0 puis la tension VM1 et enfin la tension VE0 sur toutes les lignes d'adressage, pour écrire l'état "0" dans la cellule mémoire (īj) adressée.

8. Mémoire statique selon la revendication 7, caractérisée en ce que le circuit d'adressage de chaque bascule comprend une première diode (26) connectée au drain (12) du transistor MIS correspondant pour l'adressage de mots et une seconde diode (24) pour l'adressage d'éléments binaires, connectée à la grille (16) dudit transistor MIS.

## Claims

1. Static memory cell comprising:

A) a bistable flip-flop (1) essentially formed by a MOS transistor (20) and a parasitic bipolar transistor (22) due to the structure of the MIS transistor, the source (8) and drain (12) of the MIS transistor respectively constituting the emitter and the collector of the bipolar transistor, the region of the channel (10) of the MIS transistor between the source and drain serving as the base for the bipolar transistor, said base being completely isolated from the exterior of the memory cell, the gate electrode (16) of the MIS transistor being electrically isolated from the channel (10) region and

B) an addressing circuit (23,25) for the flip-flop in order to apply with respect to the source (8) raised to a reference potential:

a) to the gate electrode (16) a voltage VG1 below the threshold voltage VBi for triggering the bipolar transistor by the MIS transistor (20) and to the drain a voltage VD1 above the threshold voltage VD0 for maintaining the bipolar transistor (22) in the triggered state in order to maintain one of the states "0" or "1",

b) to the drain (12) the voltage VD1 and to the gate electrode (16) a voltage VG2 higher than VBi or a light pulse adequate for triggering the MIS and bipolar transistors, in order to write the state "1", followed by the voltage VG1,

c) to the gate electrode (16) the voltage VG1 and to the drain (12) a voltage VD2 lower than VD0, in order to write the state "0" and then the voltage VD1.

2. Memory cell according to claim 1, characterized in that the source and drain (8,12) are formed from a zone of a first conductivity type, the channel (10) from a zone of a second conductivity type, said zones being defined in a semiconductor layer (6) supported by an electrical insulating material (4).

3. Memory cell according to claim 2, characterized in that the semiconductor layer (6) is of monocrystalline silicon.

4. Memory cell according to claim 2, characterized in that the insulating material (4) is of silicon dioxide.

5. Memory cell according to claim 1, characterized in that the addressing circuit (23,25) comprises a first electric power source (23) connected between source (8) and gate electrode (16) and a second electric power source (25) connected between source (8) and drain (12).

6. Process for storing a binary information in a static memory cell comprising a bistable flip-flop essentially formed by a MIS transistor (20), whose gate electrode (16) is electrically isolated from the region of channel (10) of the MIS transistor and a parasitic bipolar transistor (22) due to the structure of the MIS transistor, the source (8) and drain (12) of the MIS transistor respectively constituting the emitter and the collector of the bipolar transistor, the region of channel (10) of the MIS transistor located between the source and drain serving as the base for the bipolar transistor, said base being totally electrically isolated from the exterior of the memory cell, process comprises applying with respect to the source, raised to a reference potential:

a) to the gate electrode (16) a voltage VG1 below the threshold voltage VBi for triggering the bipolar transistor by the MIS transistor (20) and to the drain a voltage VD1 higher than the threshold voltage VD0 for maintaining the bipolar transistor (22) triggered, in order to maintain one of the states "0" or "1",

b) to the drain (12) voltage VD1 and to the gate electrode (16) a voltage VG2 higher than VBi or a light pulse sufficient to trigger the MIS and bipolar transistors, so as to permit the writing of state "1" and then the voltage VG1,

c) to the gate electrode (16) the voltage VG1 and to the drain (12) a voltage VD2 below VD0 in order to write the state "0" and then the voltage VD1.

7. Static memory comprising an array of memory cells distributed along addressing rows (Li) and columns (Cj) of said memory cells, characterized in that each memory cell comprises:

A) a bistable flip-flop (1) essentially formed by a MIS transistor and a parasitic bipolar transistor due to the structure of the MIS transistor, the source (8) and drain (12) of the MIS transistor (20) respectively constituting the emitter and the collector of the bipolar transistor (22), the region of the channel (10) of the MIS transistor located between the source and drain serving as the base of the bipolar transistor, said base being completely isolated from the outside of the memory cell, the gate electrode (16) of the MIS transistor being electrically isolated from the region of channel (10) and

B) an addressing circuit (24,26) for the flip-flop, the addressing of a memory cell (ij) consisting of applying, with respect to the sources of the MIS transistors raised to a reference potential:

a) to each addressing row a voltage VE0 below the threshold voltage VBi for triggering bipolar transistors by MIS transistors and to each addressing column a voltage VM1 higher than the threshold voltage VD0 for maintaining the bipolar transistors triggered, so as to maintain the stored states "0" or "1",

b) to the addressing column of the memory cell (ij) to be addressed a voltage VM2 higher than VM1 and to the addressing row of the cell to be addressed a voltage VE1 higher than voltage VBi for voltage VM2 and lower than VBi for voltage VM1, to the other addressing rows the voltage VE0 and to the other addressing columns the voltage VM1 for writing a "1" into the addressed memory cell,

c) to all the other addressing rows the voltage VE1 and to all the other addressing columns the voltage VM1 and to the addressing rows of the cell (īj) to be addressed the voltage VE0 and to its addressing column a voltage VM0 lower than VD0 and then the voltage VM1 and finally voltage VE0 to all the addressing rows, in order to write the state "0" into the addressed memory cell (īj).

8. Static memory according to claim 7, characterized in that the addressing circuit of each flip-flop comprises a first diode (26) connected to the drain (12) of the corresponding MIS transistor for the addressing of words and a second diode (24) for addressing bits connected to the gate (16) of said MIS transistor.

## Patentansprüche

1. Statische Speicherelle, welche enthält:
   A) - eine bistabile Kippstufe (1), die im wesentlichen gebildet wird von einem MIS-Transistor (20) und einem bipolaren Transistor (22), parasitär auf Grund der Struktur des Transistors MSI, wobei die Source (8) und der Drain (12) des MIS-Transistors den Emitter bzw. den Kollektor des bipolaren Transistors bilden und die Zone des Kanals (10) des MIS-Transistors, zwischen der Source und dem Drain befindlich, die Rolle der Basis des biplaren Transistors spielt, wobei diese Basis vollständig isoliert ist von der Außenseite der Speicherzelle, wobei die Gateelektrode (16) des MIS-Transistors elektrisch isoliert ist von der Zone des Kanals (10), und
   B) - eine Adressierschaltung (23, 25) der Kippstufe, um bezuglich der auf auf ein Referenzpotential gebrachten Source (8) anzulegen:
   a) an die Gateelektrode (16) eine Spannung VG1, niedriger als die Abfallschwellenspannung VBi des bipolaren Transistors durch den MIS-Transistor (20), und an den Drain eine Spannung VD1, höher als die Halteschwellenspannung VD0, ausgelöst von dem bipolaren Transistor (22), um einen der Zustände "0" oder "1" aufrechtzuerhalten,
   b) an dem Drain (12) die Spannung VD1 und an die Gateelektrode (16) eine Spannung VG2, höher als VBi, oder einen Lichtimpuls der ausreicht, den MIS-Transistor und den bipolaren Transistor auszulösen, um den Zustand "1" zu schreiben, dann die Spannung VG1,
   c) an die Gateelektrode (16) die Spannung VG1 und an den Drain (12) eine Spannung VD2, niedriger als VD0, um den Zustand "0" zu schreiben, dann die Spannung VD1.

2. Speicherzelle nach Anspruch 1, dadurch gekennzeichnet, daß die Source und der Drain (8, 12) gebildet werden aus einer Zone eines ersten Leitfähigkeittyps, der Kanal (10) aus einer Zone eines zweiten Leitfähigkeitstyps, wobei diese Zonen in einer Halbleiterschicht (6) definiert sind, getragen von einem elektrischen Isoliermaterial (4).

3. Speicherzelle nach Anspruch 2, dadurch gekennzeichnet, daß die Halbleiterschicht (6) aus monokristallinem Silizium besteht.

4. Speicherzelle nach einem der Ansprüche 2 oder 3, dadurch gekennzeichnet, daß das Isoliermaterial (4) aus Siliziumdioxid besteht.

5. Speicherzelle nach einem der Ansprüche 1 bis 4, dadurch gekennzeichnet, daß die Adressierschaltung (23, 25) eine erste Stromversorgungsquelle (23) enthält, angeschlossen zwischen der Source (8) und der Gateelektrode (16), und eine zweite Stromversorgungsquelle (25), angeschlossen zwischen der Source (8) und dem Drain (12).

6. Speicherungsverfahren einer binären Information in einer statischen Speicherzelle, die eine bistabile Kippstufe enthält, die im wesentlichen gebildet wird aus einem MIS-Transistor (20), dessen Gateelektrode (16) elektrisch isoliert ist von der Zone des Kanals (10) des MIS-Transistors und des bipolaren Transistors (22), parasitär auf Grund der Struktur des MIS-Transistors, wobei die Source (8) und der Drain (12) des MIS-Transistors den Emitter bzw. den Kollektor des bipolaren Transistors bilden, wobei die Zone des Kanals (10) des MIS-Transistors, zwischen der Source und dem Drain befindlich, die Rolle der Basis des bipolaren Transistors spielt, wobei diese Basis elektrisch vollständig isoliert ist von der Außenseite der Speicherzelle, Verfahren, darin bestehend, bezüglich der auf ein Referenzpotential gebrachten Source anzulegen:
   a) an die Gateelektrode (16) eine Spannung VG1, niedriger als die Abfallschwellenspannung VBi des bipolaren Transistors durch den MIS-Transistor (20), und an den Drain eine Spannung VD1, höher als die Halteschwellenspannung VD0, ausgelöst von dem bipolaren Transistor (22), um einen der Zustände "0" oder "1" aufrechtzuerhalten,
   b) an dem Drain (12) die Spannung VD1 und an der Gateelektrode (16) eine Spannung VG2, höher als VBi, oder einen Lichtimpuls der ausreicht, den MIS-Transistor und den bipolaren Transistor auszulösen, um den Zustand "1" zu schreiben, dann die Spannung VG1,

c) an die Gateelektrode (16) die Spannung VG1 und an den Drain (12) eine Spannung VD2, niedriger als VD0, um den Zustand "0" zu schreiben, dann die Spannung VD1.

7. Statischer Speicher, der eine Speicherzellenmatrix umfaßt, eingeteilt in Zeilen und Spalten, Adressierungszeilen (Li) und -spalten (Ci) dieser Speicherzellen, dadurch gekennzeichnet, daß jede Speicherzelle umfaßt:

A) - eine bistabile Kippstufe (1), die im wesentlichen gebildet wird von einem MIS-Transistor und einem bipolaren Transistor, parasitär auf Grund der Struktur des MIS-Transistors, wobei die Source (8) und der Drain (12) des MIS-Transistors (20) den Emitter bzw. den Kollektor des bipolaren Transistors (22) bilden und die Zone des Kanals (10) des MIS-Transistors, zwischen der Source und dem Drain befindlich, die Rolle der Basis des biplaren Transistors spielt, wobei diese Basis gänzlich isoliert ist von der Außenseite der Speicherzelle, wobei die Gateelektrode (16) des MIS-Transistors elektrisch isoliert ist von der Zone des Kanals (10), und

B) - eine Adressierschaltung (24, 26) der Kippstufe, wobei die Adressierung einer Speicherzelle (ij) darin besteht, bezüglich der auf ein Referenzpotenial gebrachten Sourcen der MIS-Transistoren anzulegen:

a) an jede Adressierzeile (Li) eine Spannung VEO, niedriger als die Abfallschwel-lenspannung VBi der bipolaren Transisto-ren durch die MIS-Transistoren, und an jede Adressierspalte (Cj) eine Spannung VM1, höher als die Halteschwellenspannung VDO, ausgelöst durch die bipolaren Transistoren, um die gespeicherten Zustände "0" und "1" aufrechtzuerhalten,

b) an die Adressierspalte der zu adres-sierenden Speicherzelle (ij) eine Span-nung VM2, höher als VM1, und an die Adressierzeile der zu adressierenden Zelle eine Spannung VE1, höher als die Spannung VBi für die Spannung VM2 und niedriger als VBi für die Spannung VM1, an die anderen Adressierzeilen die Spannung VE0, und an die anderen Adressierspalten die Spannung VM1, um eine "1" in die adressierte Speicherzelle zu schreiben,

c) an alle anderen Adressierzeilen die Spannung VE1, und an die anderen Adressierspalten die Spannung VM1, und an die Adressierzeile der zu adressieren-den Zelle (ij) die Spannung VE0, und an die Adressierspalte eine Spannung VM0, niedriger als VD0, dann die Spannung VM1 und schließlich die Spannung VE0 an alle Adressierzeilen, um den Zustand "0" in die adressierte Speicherzelle (ij) zu schreiben.

8. Statischer Speicher nach Anspruch 7, dadurch gekennzeichnet, daß die Adressierschaltung jeder Kippstufe eine erste Diode (26) enthält, angeschlossen an dem Drain (12) des entsprechenden MIS-Transistors für die Adressierung von Wörtern, und eine zweite Diode (24) für die Adressierung von binären Elementen, angeschlossen an das Gate (16) des genannten MIS-Transistors.

FIG. 1

FIG. 2

FIG.3

FIG. 4

FIG. 5